# EUROPEAN PATENT SPECIFICATION

(11) **EP 3 083 461 B1**
(45) Date of publication and mention of the grant of the patent: **18.07.2018**
(21) Application number: 14837052.1
(22) Date of filing: 19.12.2014
(51) Int. Cl.: B65H 20/06, C23C 16/509, C23C 16/54, C23C 18/02, C23C 18/12, H01L 31/0392, H01L 31/20

(54) **WEB BASED CHEMICAL BATH DEPOSITION APPARATUS**
WEBBASIERTE VORRICHTUNG FÜR CHEMISCHE BADABSCHEIDUNG
APPAREIL DE DÉPÔT PAR BAIN CHIMIQUE BASÉ SUR UN VOILE

(30) Priority: 20.12.2013 US 201361918748 P
(43) Date of publication of application: 26.10.2016
(73) Proprietor: Nuvosun, Inc., Milpitas, CA 95035 (US)
(72) Inventor: HACHTMANN, Bruce, San Martin, CA 95046 (US); CLOVER, Preston, Midland, Michigan 48674 (US); HOLLARS, Dennis, Madera, CA 93636 (US); WALL, Arthur, C., Morgan Hill, CA 95037 (US); TAYLOR, Rocky, Los Gatos, CA 95033 (US); PENG, Gang, Grant, Fremont, CA 94539 (US)
(74) Representative: Beck Greener
(86) International application number: PCT/US2014/071442
(87) International publication number: WO 2015/095674

(56) References cited:
- EP-A2- 2 562 108
- WO-A1-2009/111054
- WO-A2-2009/075944
- US-A1- 2003 006 218
- US-A1- 2009 246 908

## Description

### BACKGROUND

### Field of the Invention

The invention relates to web-based chemical bath deposition.

### Description of the Related Art

In examples, thin film solar cells on flexible substrates include amorphous silicon disposed on a thin metal foil (e.g., stainless steel) and copper indium gallium diselenide (CIGS) on metallic or polyimide foils. Thin film cadmium telluride (CdTe) solar cells may be produced on glass, but may also be produced on a flexible substrate. Manufacturing solar cells may involve deposition and formation of layers on the flexible substrate. Document US 2009/0246908 discloses a web transport system wherein a belt conveyor equipped with magnetic elements transports and shapes a web.

### SUMMARY

In one aspect, the present disclosure describes a system for processing a web, where the web has a first surface, a second surface opposite the first surface, and includes a magnetic material. The system includes a processing bed, where the processing bed is configured to support the web while the first surface of the web undergoes one or more processing steps, and where the processing bed includes a center portion having a flat surface and side portions having curved surfaces. The system also includes a plurality of magnets, where the plurality of magnets are positioned relative to the processing bed so as to exert a magnetic force on the web that pulls the web toward the processing bed, and where the magnetic force is sufficient to shape the web so that the web substantially conforms to the flat surface and curved surfaces of the processing bed. The system further includes a conveyor belt configured to move the web over the processing bed while the web is shaped by the magnetic force to substantially conform to the flat surface and curved surfaces of the processing bed. The conveyor belt has a first contact surface and a second contact surface opposite the first contact surface, where the first contact surface is configured to contact the second surface of the web, and where the second contact surface is configured to contact the processing bed.

In another aspect, the present disclosure describes a method for processing a web, where the web has a first surface, a second surface opposite the first surface, and includes a magnetic material. The method includes supporting the web using a processing bed while the first surface of the web undergoes one or more processing steps, where the processing bed includes a center portion having a flat surface and side portions having curved surfaces. The method also includes applying a magnetic force on the web using a plurality of magnets positioned relative to the processing bed so as to pull the web toward the processing bed, where the magnetic force is sufficient to shape the web so that the web substantially conforms to the flat surface and curved surfaces of the processing bed. The method further includes moving the web over the processing bed using a conveyor belt while the web is shaped by the magnetic force to substantially conform to the flat surface and curved surfaces of the processing bed. The conveyor belt has a first contact surface and a second contact surface opposite the first contact surface, where the first contact surface is configured to contact the second surface of the web, and where the second contact surface is configured to contact the processing bed.

In still another aspect, the present disclosure describes an apparatus for processing a web, where the web has a first surface, a second surface opposite the first surface, and includes a magnetic material. The apparatus includes a plurality of magnets embedded in a processing bed configured to support the web, where the processing bed includes a center portion having a flat surface and side portions having curved surfaces that extend upwardly from opposite sides of the flat surface of the processing bed, and where the plurality of magnets are configured to apply a magnetic force on the web that pulls the web toward the processing bed to shape the web into a trough that substantially conforms to the flat surface and curved surfaces of the processing bed. The apparatus also includes a conveyor belt configured to move the web over the processing bed while the web is shaped by the magnetic force to substantially conform to the flat surface and curved surfaces of the processing bed. The conveyor belt has a first contact surface and a second contact surface opposite the first contact surface, where the first contact surface is configured to contact the second surface of the web, and where the second contact surface is configured to contact the processing bed.

The foregoing summary is illustrative only and is not intended to be in any way limiting. In addition to the illustrative aspects, embodiments, and features described above, further aspects, embodiments, and features will become apparent by reference to the figures and the following detailed description.

### BRIEF DESCRIPTION OF THE FIGURES

Figure 1 is a flow chart illustrating a method for shaping a moving web, in accordance with an example embodiment.
Figure 2A illustrates a system for processing a web, in accordance with an example embodiment.
Figure 2B illustrates a portion of the system shown in Figure 2A, in accordance with an example embodiment.
Figure 2C illustrates a processing bed in the portion illustrated in Figure 2B, in accordance with an example embodiment.
Figure 3A illustrates a side portion of a processing bed, in accordance with an example embodiment.
Figure 3B illustrates an array of magnets embedded in the side portion, in accordance with an example embodiment.
Figure 4 illustrates a web conforming to a flat surface and curved surfaces of the processing bed, in accordance with an example embodiment.
Figure 5 illustrates a conveyor belt disposed between the processing bed and the web, in accordance with an example embodiment.
Figure 6 is a flow chart illustrating a method for forming a layer from a fluid mixture on a web, in accordance with an example embodiment.
Figure 7 illustrates a fluid delivery apparatus for dispensing a stream of a first fluid of the fluid mixture and a stream of a second fluid of the fluid mixture onto a cascade device, in accordance with an example embodiment.
Figure 8A illustrates a fluid stirring apparatus for generating a flow pattern for stirring the fluid mixture on the web, in accordance with an example embodiment.
Figure 8B illustrates a side view of the fluid stirring apparatus depicted in Figure 8A, in accordance with an example embodiment.
Figure 9 illustrates an apparatus for providing thermal differencing between sections of the processing bed, in accordance with an example embodiment.
Figure 10 illustrates a fluid removal apparatus for removal of residual material and debris, in accordance with an example embodiment.

### DETAILED DESCRIPTION

The following detailed description describes various features and functions of the disclosed systems and methods with reference to the accompanying figures. In the figures, similar symbols identify similar components, unless context dictates otherwise. The illustrative system and method embodiments described herein are not meant to be limiting. It may be readily understood that certain aspects of the disclosed systems and methods can be arranged and combined in a wide variety of different configurations, as defined by the appended claims.

The terms "photovoltaic cell" (also "solar cell" herein), as used herein, generally refers to a device comprising a photoactive material (or absorber) that is configured to generate electrons (or electricity) upon exposure of the device to electromagnetic radiation (or energy), or a given wavelength or distribution of wavelengths of electromagnetic radiation. Solar cells may be electrically connected in series with other similar solar cells to raise the voltage levels and minimize resistive losses that would otherwise occur due to high currents. In some examples, a large number of solar cells can be serially connected and integrated into solar modules that are several meters long.

Forming photovoltaic cells may involve making use of thin-film, light-absorbing semiconductor materials. An example photovoltaic cell may include a stainless steel web substrate. The stainless steel web substrate may be a flexible substrate. In an example, processing the stainless steel web substrate to form the photovoltaic device may include forming a molybdenum (Mo) layer on a backside of the stainless steel web substrate. Thereafter processing may occur on a front side of the stainless steel substrate. For instance, a chromium (Cr) layer may be formed adjacent to the substrate and a Mo layer may be formed over the Cr layer. An absorber layer that in the cell converts light to electricity may be the next layer. This is typically a p-type layer. Preferred absorbers are copper chalcogenides, such as copper indium selenides, sulfides or selenide sulfide (together referred to as CIS layers). Copper indium gallium selenides (CIGS) are preferred. The absorber layer may be doped with sodium (Na). An n-type layer may be formed as a buffer layer over the absorber layer. Cadmium Sulfide (CdS) buffer layer is preferred. The method of this invention is suitable for use in forming this buffer layer.. Further, additional transparent conductor layers and other layers may be formed over the buffer layer by standard methods. For example, in one preferred embodiment a resistive zinc oxide (ZnO) layer may be formed over the buffer layer and a transparent conductive oxide (TCO, for example indium tin oxide or aluminum zinc oxide) layer may be formed over the zinc oxide layer.

In examples, forming the component layers of the photovoltaic cell may involve a plurality of roll-to-roll deposition systems or stages. As an example, in a first stage, the backside of a stainless steel web substrate is coated with a back side Mo layer, and the front side of the stainless steel substrate is coated with a back electrode Cr/Mo, an alkali metal sodium fluoride (NaF) layer, and a precursor CIGs layer. Within a second stage, the CIGs precursor may be fully reacted to form photoactive CIGS. In a third stage, the CdS buffer layer may be deposited. In a fourth stage, a transparent oxide layers (ZnO/TCO) may be deposited.

These stages, systems, or processing steps are examples for illustration only. More or less steps/stages may be used and different material can be used to form a given photovoltaic cell. Forming a buffer layer on top of a web-based photovoltaic absorber layer (e.g., forming a CdS layer) may involve depositing a fluid mixture on the web and the absorber layer coupled thereto. Depositing the fluid mixture to form a uniform buffer layer over the web may involve multiple challenges. For example, it may be desirable to provide precise geometric control and thermal control of the web as the web moves across the multiple processing stages as the buffer layer is being formed. As described above, the web, e.g., stainless steel flexible substrate, may be received in the form of a roll. The roll may be unwound to provide a flat web on which one or more uniform layers can be formed. A first challenge may involve providing the web with a sufficiently planar surface, for example, a surface that is flat to within less than a millimeter over a width of about a meter and a length of tens of meters.

Another challenge may involve mixing multiple fluids to be deposited on the web. As an example, assuming two or more fluids are to be mixed, the fluids may be mixed remotely and then delivered to the processing system for deposition on the web. The mixed fluids, which are reactive, may be delivered via multiple valve systems and conduits to the processing system. The mixed reacting or active fluids may interact with components of the delivery system may thus be contaminated with particles that eventually are also deposited on the web.

Still another challenge may involve agitating the fluids to provide for a better mixing without contaminating the fluids within the constraints of forming a uniform thin layer (e.g., a fluid with a depth of 5-10 mm) over the web. Yet still another challenge may involve removal of excess fluids and debris (e.g., CdS particles that have nucleated within the fluid mixture) from the web upon formation of the layer.

Disclosed herein are methods and systems that can address the aforementioned challenges. The methods and systems involve shaping a moving web so that it is sufficiently flat to form a uniform layer while still being able hold a fluid mixture that forms the layer, providing for proper mixing and agitation of the fluids without contamination, and providing for removal of residual material and debris. The methods and systems are described in the context of photovoltaic cells as an example for illustration only. The methods and systems described herein generally relate to depositing any type of layer over any type of web.

### I. Shaping a Moving Web

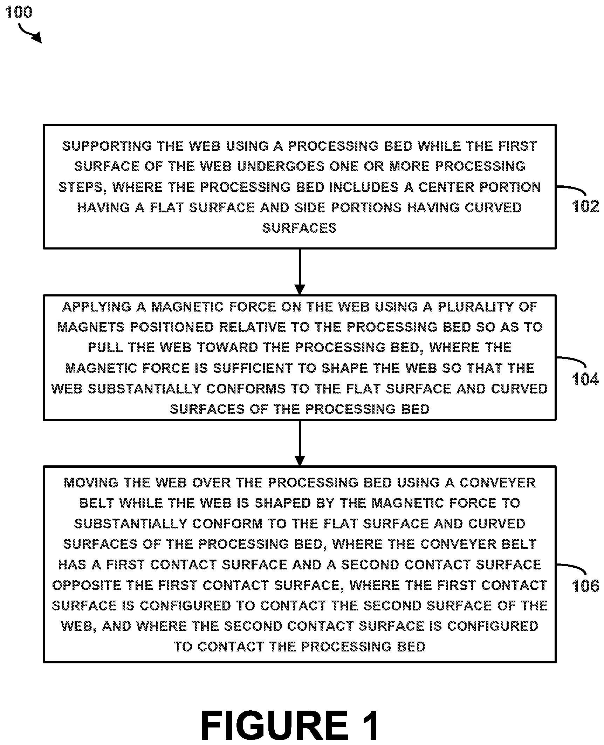

Figure 1 is a flow chart illustrating a method 100 for shaping a moving web, in accordance with an example embodiment. The method 100 may include one or more operations, functions, or actions as illustrated by one or more of blocks 102-106. Although the blocks are illustrated in a sequential order, these blocks may in some instances be performed in parallel, and/or in a different order than those described herein. Also, the various blocks may be combined into fewer blocks, divided into additional blocks, and/or removed based upon the desired implementation.

In this example, the web has a first surface (where the formation of a CdS layer or a different material deposited by chemical bath deposition or other processing occurs, for example) and a second surface opposite the first surface. The web also includes a magnetic material, such as a substrate composed of a magnetic form of stainless steel.

At block 102, the method 100 includes supporting the web using a processing bed while the first surface of the web undergoes one or more processing steps, where the processing bed includes a center portion having a flat surface and side portions having curved surfaces.

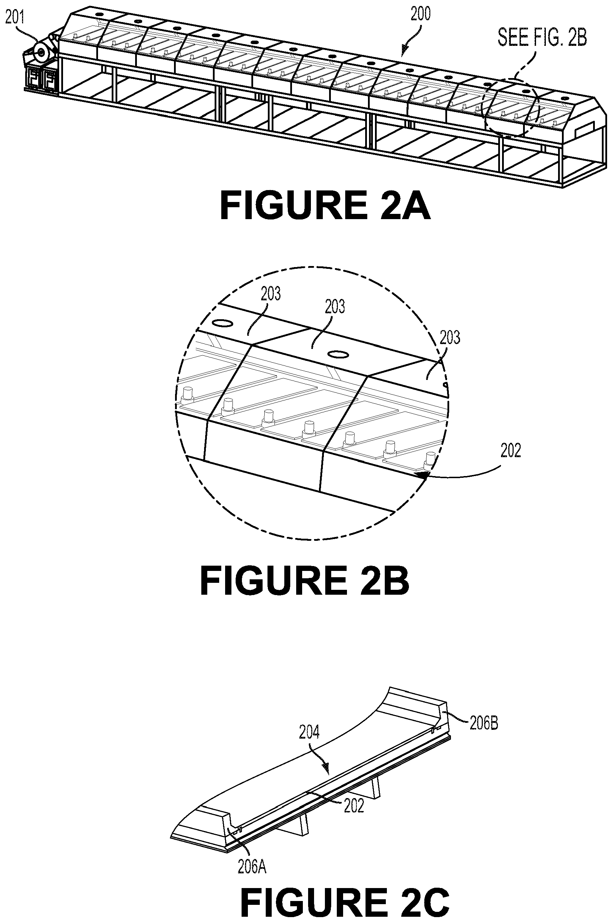

Figure 2A illustrates a system 200 for processing a web, in accordance with an example embodiment. Figure 2A depicts system (or apparatus) 200 that may include a plurality of processing stages for the web. The system 200 may be configured for depositing a layer from a chemical fluid mixture bath on a web. Thus, the system 200 may be referred to as chemical bath deposition system or apparatus. Figure 2B illustrates a portion of the system 200, in accordance with an example embodiment. As shown, the portion of system 200 includes a processing bed 202 underneath one or more processing systems 203. The web from roll 201 may be conveyed through system 200 such that the web is supported by the processing bed 202 while it undergoes processing by the one or more processing systems 203.

Figure 2C illustrates in more detail the processing bed 202 in the portion illustrated in Figure 2B, in accordance with an example embodiment. The processing bed 202 may include a center portion 204 having a flat surface and side portions 206A and 206B having curved surfaces as shown in Figure 2C. The curved surfaces of the side portions 206A and 206B may be configured to extend upwardly (e.g., curl or angle upwardly) from opposite sides of the flat surface of the center portion 204 of the processing bed 202 as shown in Figure 2C. In this manner, the processing bed 202 may be configured to have a trough-like shape.

Referring back to Figure 1, at block 104 the method 100 includes applying a magnetic force on the web using a plurality of magnets positioned relative to the processing bed so as to pull the web toward the processing bed, where the magnetic force is sufficient to shape the web so that the web substantially conforms to the flat surface and curved surfaces of the processing bed. The processing bed 202 shown in Figure 2C may include a plurality of magnets. The plurality of magnets may be embedded in the processing bed 202 proximate to both the center portion 204 and the side portions 206A and 206B.

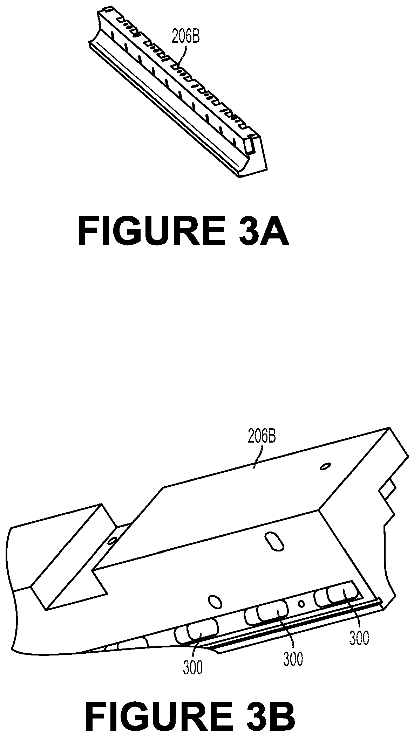

Figure 3A illustrates the side portion 206B of the processing bed 202, in accordance with an example embodiment. Figure 3B illustrates an array of magnets 300 embedded in the side portion 206B, in accordance with an example embodiment. A similar array of magnets (not shown) may be also embedded in the center portion 204 and the side portion 206A of the processing bed 202.

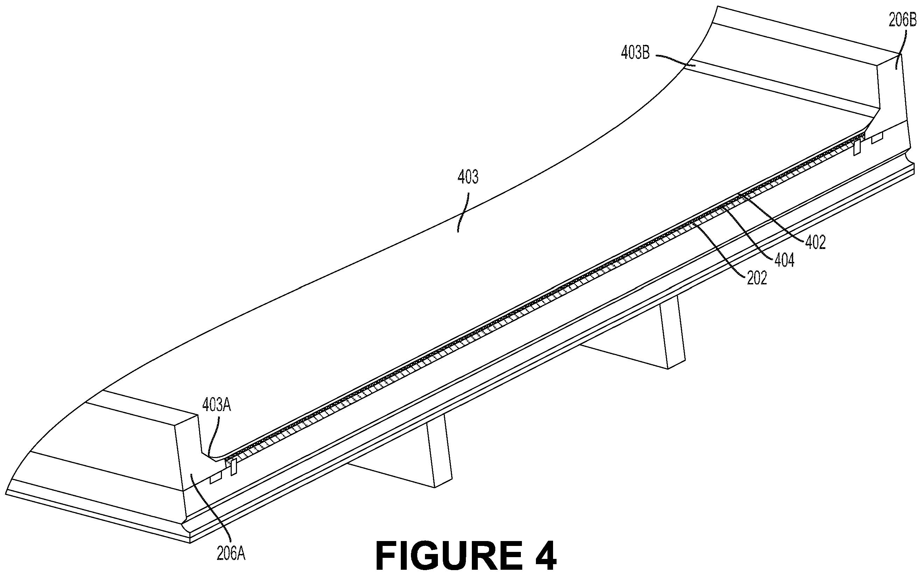

Figure 4 illustrates a web 402 conforming to the flat surface and curved surfaces of the processing bed 202, in accordance with an example embodiment. As indicated above, the web 402 includes a magnetic material. In examples, the web 402 may be a coated metal or coated metallized polymer. In one example, the web 402 may include a magnetic stainless steel (e.g., Ferritic and Martensitic stainless steel, such as grade 413 stainless steel). The array of magnets (e.g., the array of magnets 300) embedded in the processing bed 202 may be configured to interact with the magnetic material of the web 402. For instance, the array of magnets may be positioned relative to the processing bed 202 so as to exert a magnetic force on the web 402 that pulls the web 402 toward the processing bed 202. The magnets are configured to exert a sufficient force that shapes the web 402 so that the web 402 substantially conforms to the flat surface and curved surfaces of the processing bed 202. In an example, the array of magnets such as the array of magnets 300 may include movable permanent magnets. In this example, locations or positions of the array of magnets may be adjusted so as to adjust a magnetic force or magnetic field produced by the array of magnets. In another example, the array of magnets may be an array of electromagnets that can be controlled via an electric current. The electromagnets can thus be turned on or off and strength of the magnetic field/force produced can be adjusted.

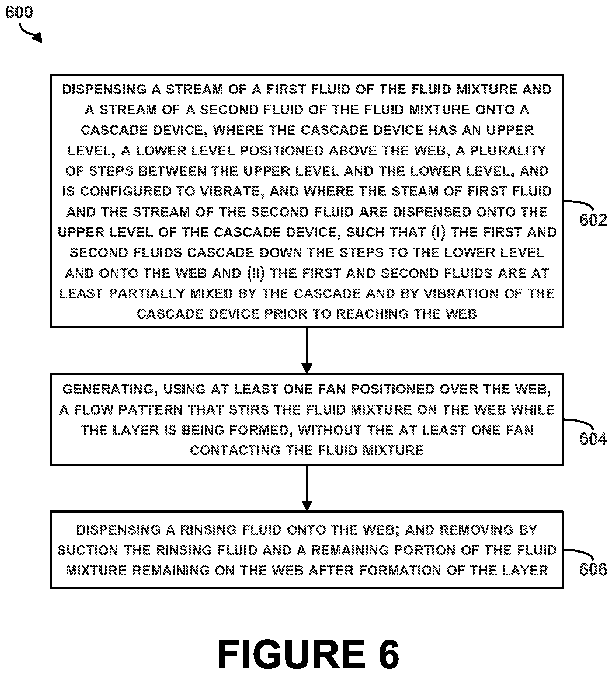

In this manner, the web 402 is shaped to include a center portion 403 having a flat shape that conforms to the flat surface of center portion 204 of processing bed 202 and side portions 403A and 403B that curve upwards to substantially conform to curved surfaces of side portions 206a and 206b, respectively, of processing bed 202. Thus, the forces exerted by the magnets makes web 402 trough-shaped based on the trough shape of the processing bed 402. As described below with respect to the method 600 of Figure 6, the trough shape of the web 402 facilitates fluid containment (e.g., keeping the fluid on one side of the web 402).

In some examples, in addition or alternative to, the processing bed 202 having an array of magnets (e.g., the array of magnets 300), the processing bed may be made of magnetic material (entirely or partially) that interacts with the magnetic material of the web 402 to pull the web 402 downwards.

Referring back to Figure 1, at block 106 the method 100 includes moving the web over the processing bed using a conveyor belt while the web is shaped by the magnetic force to substantially conform to the flat surface and curved surfaces of the processing bed. The conveyor belt has a first contact surface and a second contact surface opposite the first contact surface. The first contact surface is configured to contact the second surface of the web, and the second contact surface is configured to contact the processing bed. Figure 4 depicts a conveyor belt 404 disposed between the web 402 and the processing bed 202, and configured to move the web 402 over the processing bed 202.

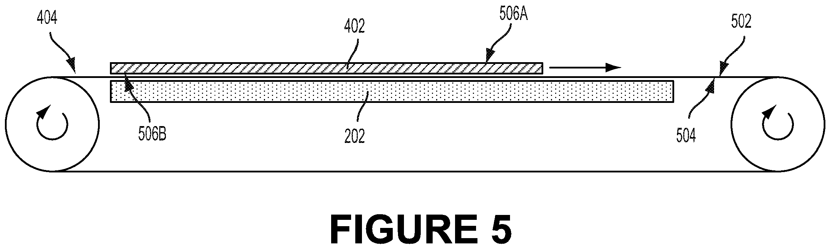

Figure 5 illustrates the conveyor belt 404 disposed between the processing bed 202 and the web 402, in accordance with an example embodiment. The conveyor belt 404 has a first contact surface 502 and a second contact surface 504 opposite the first contact surface 502. The web 402 has a first surface 506A and a second surface 506B opposite the first surface. The first surface of the web 402 may be facing upwards and may undergo several processing steps as described below with respect to the method 600. The second surface of the web 402 may be configured to contact the first contact surface 502 of the conveyor belt 404. The second contact surface 504 is configured to contact the processing bed 202 as shown in Figure 5.

In examples, the first contact surface 502 of the conveyor belt 404 may be configured to have a high coefficient of friction so as to apply traction to the second surface 506B of the web 402 such that the web 402 moves along with the conveyor belt 404. The second contact surface 504 of the conveyor belt 404 may have a low coefficient of friction (e.g., lower than the coefficient of friction of the first contact surface 502) so as to slide over and move relative to the flat surface of the processing bed 202. Thus, as the conveyor belt 404 moves/rotates, the web 402 moves with the conveyor belt 404 while the processing bed 202 remains stationary. Although the conveyor belt 404 is shown in Figure 5 to move in a certain direction (e.g., rotation in clockwise direction), in other cases the conveyor belt 404 and the web 402 may move in an opposite direction.

The array of magnets embedded in the processing bed 202 is configured to interact with the magnetic material of the web 402 through the conveyor belt 404. Thus, the forces exerted by the magnets cause the web 402 to maintain the trough shape described above while the web is being moved by conveyor belt 404. The difference in respective coefficients of friction of the first contact surface 502 and the second contact surface 504 decouples the friction between the web 402 and processing bed 202 having the array of magnets embedded therein because there is no direct contact between the web 402 and the processing bed 202. Thus, motion, speed, and tension of the web 402 are decoupled from the processing bed 202 and such decoupling may prevent breakage of the web 402 as the web 402 is being carried by the conveyor belt 404 through the plurality of stages or processing steps of the system 200. The conveyor belt 404 is configured to move the web 402 through the plurality of stages or processing steps of the system 200 so as to form a layer from a fluid mixture on the first surface 506A of the web 402.

### II. Fluid Handling

Figure 6 is a flow chart illustrating a method 600 for forming a layer from a fluid mixture on a web, in accordance with an example embodiment. The method 600 may include one or more operations, functions, or actions as illustrated by one or more of blocks 602-606. Although the blocks are illustrated in a sequential order, these blocks may in some instances be performed in parallel, and/or in a different order than those described herein. Also, the various blocks may be combined into fewer blocks, divided into additional blocks, and/or removed based upon the desired implementation.

At block 602, the method 600 includes dispensing a stream of a first fluid of the fluid mixture and a stream of a second fluid of the fluid mixture onto a cascade device. The cascade device has an upper level, a lower level positioned above the web, a plurality of steps between the upper level and the lower level, and is configured to vibrate. The stream of first fluid and the stream of the second fluid are dispensed onto the upper level of the cascade device, such that (i) the first and second fluids cascade down the steps to the lower level and onto the web and (ii) the first and second fluids are at least partially mixed by the cascade and by vibration of the cascade device prior to reaching the web.

In examples, any number of fluids can be mixed to form a layer on the web. The method 600 is described herein using a mixture of two fluids as an example for illustration only. As an example for illustration, the first fluid may be a chemical solution including cadmium sulfate (CdSO₄) and ammonia hydroxide (NH₄OH) while the second fluid may be a chemical solution including thiourea (SC(NH₂)₂). In this example, the resulting layer depositing on the web may thus include cadmium sulfide (CdS). As an alternative, a layer of zinc sulfide or indium sulfide could be formed by substituting either zinc sulfate (ZnSO₄) or indium sulfate (In₂(SO₄)₃ in place of the cadmium sulfate (CdSO₄). In one example, the first fluid and the second fluid may be mixed at mixing stations remote from the web surface and then transported as a ready to react mixture to a distribution nozzle or any other distribution means to be deposited on the surface of the web. However, overtime the mixture may interact with valves, pipes, components, etc. of the transportation system and may thus generate debris and contaminants that are mingled with the fluid mixture to be deposited on the web.

In another example, alternative to mixing the fluids at a remote station, the stream of the first fluid and the stream of the second fluid are each brought separately to a distribution head (e.g., including one or more nozzles) above the web, and are each individually presented onto a vibrating cascade that mixes the solutions just prior to their falling from the cascade onto the surface of the web. In this manner, no debris or contaminants are generated from interaction of an already reacting fluid mixture with components and transmission lines of the fluid transportation system.

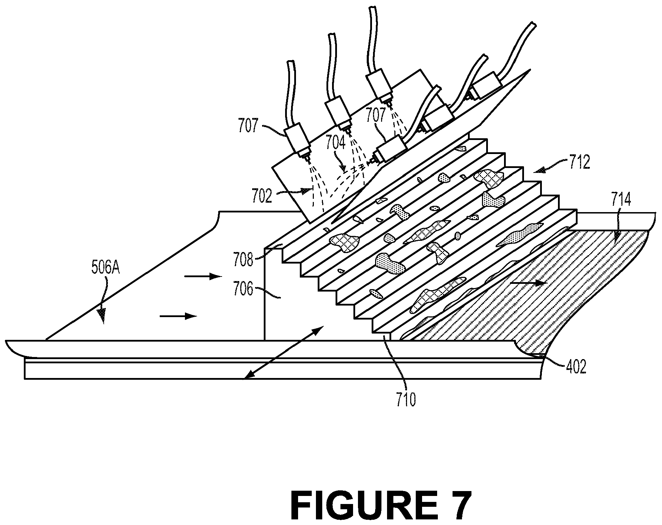

Figure 7 illustrates a fluid delivery apparatus dispensing a stream of a first fluid 702 of the fluid mixture and a stream of a second fluid 704 onto a cascade device 706, in accordance with an example embodiment. The fluid delivery apparatus may include a chemical dispenser device, such as nozzles 707 shown in Figure 7, configured to dispense the stream of the first fluid 702 and the stream of the second fluid 704 onto the cascade device 706. The cascade device 706 may have an upper level 708 and a lower level 710 positioned above the web 402 (e.g., at a predetermined distance from the first surface 506A of the web 402). The cascade device 706 may also include a plurality of steps 712 between the upper level 708 and the lower level 710.

Further, the cascade device 706 may be configured to vibrate. For example, the cascade device 706 may be configured to oscillate in a lateral, longitudinal, vertical direction or a combination thereof. The cascade device 706 may be configured to vibrate at a predetermined frequency or according to a predetermined frequency and direction profile over time. Any mechanism configured to cause vibration of the cascade device 706 can be used. The mechanism, for example, could utilize an electric system (e.g., electric motors), a hydraulic system, an electro-mechanical system, an electro-hydraulic system, etc. to cause the cascade device 706 to vibrate.

In this manner, as the stream of first fluid 702 and the stream of the second fluid 704 are dispensed onto the upper level 708 of the cascade device 706, the first fluid 702 and second fluid 704 cascade down the steps 712 to the lower level 710 and onto the web 402. Cascading the first fluid 702 and the second fluid 704 down the steps 712 while the cascade device 706 vibrates facilitates at least partial mixing of the fluids 702 and 704 prior to reaching the web 402. In one example, the first fluid 702 and the second fluid 704 may be fully mixed before reaching the web 402.

A fluid mixture 714 of the first fluid 702 and the second fluid 704 dispensed onto the web 402 may form a solution having a given thickness or depth, e.g., in the range of 1 - 10 millimeters, covering the first surface 506A of the web 402. Any fluid depth can be utilized based on the type of the web 402, the fluids being deposited, the layer to be created, etc. As described with respect to Figure 4, the web 402 may be trough-shapes with a center portion 403 having a flat surface and side portions 403A, 403B that curve upwards to substantially conform to the shape of the processing bed 202. The trough shape of the web 402 facilitates containing the fluid mixture 714 on the first surface 506A of the web 402 while the first surface 506A of the web 402 undergoes further processing steps.

Referring back to Figure 6, at block 604, the method 600 includes generating, using at least one fan positioned over the web, a flow pattern that stirs the fluid mixture on the web while the layer is being formed, without any fan contacting the fluid mixture. To facilitate formation of a uniform layer from the mixture of fluids dispensed onto the surface of the web, a stirring (or agitation) apparatus may be used to provide for mixing of the solution in contact with the surface of the web. Preferably, the stirring apparatus is configured to provide for mixing the solution without contaminating the reaction of the fluid mixture, damaging the surface of the web, or generating any debris.

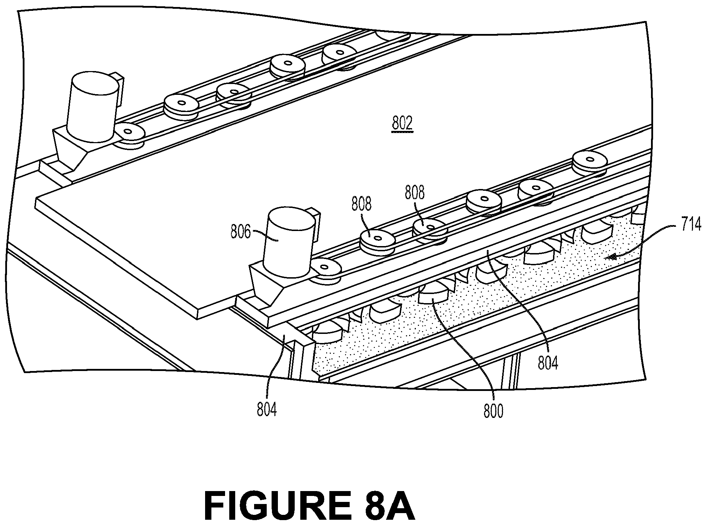

Figure 8A illustrates a fluid stirring apparatus for generating a flow pattern for stirring the fluid mixture 714 on the web 402, in accordance with an example embodiment. In some examples, the system 200 may include one or more heaters (not shown) configured to heat the processing bed 202 supporting the web 402. Heat generated by the one or more heaters may be transferred (e.g., by conduction) to the web 402 and the fluid mixture 714 dispensed thereon, and may facilitate reaction of the first fluid 702 and the second fluid 704 to enable formation of a layer. As a result of the reaction, gas or vapor and heat may be generated. For example, if the first fluid 702 includes cadmium sulfate and the second fluid 704 includes thiourea, the vapor may include ammonia or ammonia-based gas. Figure 8A depicts glass panels 802 and a sealing surface 804 that form an enclosure configured to confine the vapor and heat released by the chemical reaction of the fluid mixture 714 dispensed onto the first surface 506A of the web 402.

Further, Figure 8A depicts that the enclosure, at least partially, surrounds an array of fans 800 configured to distribute the vapor and heat released from the fluid mixture 714. In some examples, in addition to the vapor released from the chemical reaction, the system 200 may include means for injecting gases (e.g., an inert gas) in the enclosure to be distributed and circulated uniformly over the fluid mixture 714 by the array of fans 800.

The fluid stirring apparatus may be configured to cause fans of the array of fans 800 to rotate by any actuation means such as electric motor 806, for example. The electric motor 806 as depicted in Figure 8A is configured to control an array of pulleys 808 that corresponds to the array of fans 800 and configured to drive the array of fans 800 in a given direction and at a given speed. Using the electric motor 806 and the pulleys 808 is an example for illustration only, and any other driving mechanism can be used to drive the array of fans 800. For example, each fan of the array of fans 800 can be driven by a corresponding electric motor.

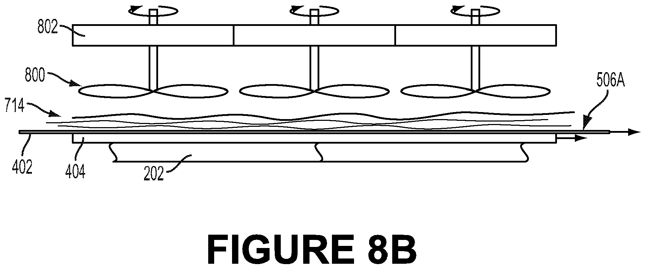

Figure 8B illustrates a side view of the fluid stirring apparatus depicted in Figure 8A, in accordance with an example embodiment. As depicted in Figure 8B, the array of fans 800 does not physically contact or contaminate the fluid mixture 714. Thus, no debris or contaminants are produced as a result of stirring the fluid mixture 714. Also, the first surface 506A of the web 402 is not damaged because of lack of physical contact between the array of fans 800 and the web 402.

In one example, the fluid stirring apparatus may be configured to control the array of fans 800 to rotate in a given direction at a given speed for a given amount of time. In other examples, the fluid stirring apparatus may be configured to control speed and direction of rotation of the array of fans 800 over repeated cycles in an oscillatory manner. For example, a given cycle may include the array of fans 800 rotating in a first direction for a first predetermined amount of time; stopping rotation for a second predetermined of time; and rotating in a second direction opposite to the first direction for a third predetermined amount of time. In some examples, fans of the array of fans 800 may not all be rotating in the same direction and at the same speed. For instance, some fans may rotate in a given direction, while others rotate in the opposite direction, while others may not be rotating. Also, in examples, individual fans may rotate at different speeds. In this manner, the fluid stirring apparatus may be configured to create a laminar flow and/or turbulent flow in the fluid mixture 714 depending on the type of fluids and the chemical reaction.

Thus, the one or more heaters in combination with the array of fans 800 may be configured to control vapor movement and heat distribution in the enclosure. For example, rotation of the array of fans 800 may cause vapor pressure to be applied to the fluid mixture 714 and may generate a flow pattern or waves in the fluid mixture 714 causing the fluid mixture 714 to be stirred or agitated. Controlling the rotation cycles of the array of fans 800 can be used to optimize mixing of the fluids in the fluid mixture 714 and may cause a predetermined temperature profile to be maintained in the fluid mixture 714. The agitation and the temperature profile maintained in the fluid mixture 714 may facilitate reaction within the fluid mixture 714 and formation of a uniform layer over the web 402.

As described above, one or more heaters may be used to heat the processing bed 202. In some examples, the processing bed 202 may be divided into separate sections, each section being heated to a respective temperature. As an example for illustration, a section of the processing bed 202, where the cascade device 706 is disposed and the fluid mixture 714 is dispensed onto the web 402, may be heated to an elevated temperature. As the web 402 moves to other sections of the processing bed 202, temperature may be raised gradually to create a temperature gradient that facilitates chemical reaction within the fluid mixture 714. For instance, a following section may be heated to a temperature of 65°C-90°C. To cause different sections of the processing bed 202 to be heated to different temperature without causing heat to be transferred from section to another, thermal dividers can be used to thermally isolate individual sections of the processing bed 202 from each other.

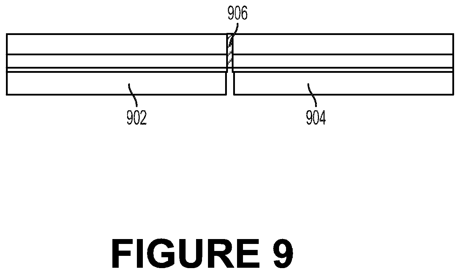

Figure 9 illustrates an apparatus for providing thermal differencing between sections of the processing bed 202, in accordance with an example embodiment. Figure 9 depicts a first section 902 of the processing bed 202, and a second section 904 of the processing bed separated by a thermal divider 906. The thermal divider 906 thermally isolates the first section 902 from the section 904 and thus allows each section to be heated to a different temperature. Such thermal isolation between the sections allows a temperature gradient to be generated across the processing bed 202 and facilitates chemical reaction within the fluid mixture 714.

Referring back to Figure 6, at block 606, the method 600 includes dispensing a rinsing fluid onto the web; and removing by suction the rinsing fluid and a remaining portion of the fluid mixture remaining on the web after formation of the layer. During formation of the layer on the web, particles (e.g., CdS particles) may have nucleated within the fluid mixture. Not all particles become part of the layer. Some particles may constitute debris to be removed so as to prevent contamination of the formed layer. Also, in an example, not all the fluid mixture dispensed on the web is used for formation of the layer, and excess fluid mixture may remain as a residual material after formation of the layer.

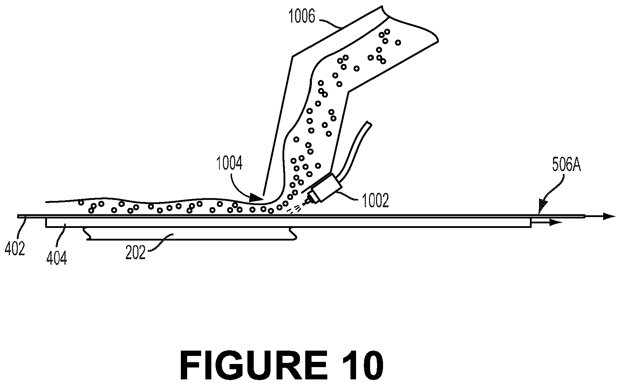

Figure 10 illustrates a fluid removal apparatus for removal of residual material and debris, in accordance with an example embodiment. The fluid removal apparatus includes a rinsing device and a suction device. Figure 10 depicts a combination of a nozzle 1002 (as an example rinsing device) and a vacuum head 1004 (as an example suction device) configured for removal of residual material and debris from the surface of the web 402. Although one nozzle 1002 is depicted in Figure 10, a plurality of nozzles can be used to dispense a rinsing fluid or rinsate. For example, the rinsate could include deionized water, surfactant or any number of fluids or mixtures.

The nozzle 1002 may be configured to dispense the rinsing fluid or rinsate on the web 402 as the web 402 moves (via the conveyor belt 404). As the nozzle 1002 dispense the rinsing fluid onto the surface of the web 402, the rinsing fluid forms a standing wave (or dam) that raises liquid level of the excess fluid locally as shown in Figure 10. The rinsing fluid also loosens or knocks excess particles off of the first surface 506A of the web 402 and/or surface of the formed layer.

The vacuum head 1004 may be configured to apply suction at a predetermined height above the web 402. The rinsing fluid dispensed by the nozzle 1002 may locally raise the liquid level of the excess fluid to at least the predetermined height above the web 402. The suction applied by the vacuum head 1004 pulls the fluid up in a substantially perpendicular direction to the first surface 506A of the web 402. The material pulled up by the vacuum head 1004 enters a vacuum manifold 1006 and is transported through the vacuum manifold 1006 to, for example, a waste collection compartment. Thus, excess fluid and particles are removed and are not left to contaminate the surface of the web 402.

While the vacuum head 1004 applies suction onto the surface of the web 402 to pull the excess material up, the magnetic force exerted by interaction of the array of magnets embedded in the processing bed 202 and the magnetic material of the web 402 keeps the web 402 held down and constrained to the processing bed 202 such that the web 402 is not pulled up along with the excess material as the suction force of the vacuum head 1004 is applied.

The system 200 may include more modules or apparatuses for further processing. For instance, the system 200 may include a cleaning apparatus configured to clean the web 402 and the layer formed thereon via any type of suitable cleaning solution. In another example, the system 200 may include a drying apparatus configured to dry the (e.g., via an air knife or any other device) the web 402 and the layer formed thereon. In still another example, the system 200 may include an uncurling apparatus configured to uncurl edges of the web 402 after formation of the layer to make the web 402 substantially planar. In yet still another example, the system 200 may include a rolling apparatus that is configured to re-roll the web 402 after formation of the layer. In this example, the system 200 may be referred to as a roll-to-roll system as the web 402 may have been received as a roll 201 that is unwound for processing and deposition of the layer and re-rolled again after formation of the layer. The system 200 may include other modules or apparatuses for post-treatment and/or pre-treatment of the web 402.

Further, in some examples, the system 200 may include a variety of sensors that might be installed along the path that the web 402 travels through the system 200. As examples, the system 200 may include a thickness sensor configured to detect thickness of the coated web 402. The system 200 may also include an optical sensor configured to detect surface imperfections on the layer formed on the web 402. Other sensors may be configured to detect chemical composition either on surface and/or through depth of coating and the system 200 may be configured to control dispensing the first fluid 702 and the second fluid 704 (Figure 7) accordingly. These sensors are examples for illustration only, and other types of sensors can be used in the system 200.

The methods and systems described in Figures 1-10 facilitate providing a moving web with a trough-like shape, providing for proper mixing and agitation of the fluids without contamination, and providing for removal of residual material and debris without recontamination of the fluid mixture. In one example, the methods and systems described in Figures 1-10 may be implemented to form a buffer layer (e.g., CdS) in a solar cell from a fluid mixture deposited onto a moving web. However, the methods and systems described in Figures 1-10 can be used to form any type of liquid layer onto a moving web of any type for chemical reaction or film deposition or a combination of both.

While the present method and/or apparatus has been described with reference to certain implementations, it will be understood by those skilled in the art that various changes may be made and equivalents may be substituted without departing from the scope of the present method and/or apparatus. In addition, many modifications may be made to adapt a particular situation or material to the teachings of the present disclosure without departing from its scope. Therefore, it is intended that the present method and/or apparatus not be limited to the particular implementations disclosed, but that the present method and/or apparatus will include all implementations falling within the scope of the appended claims.

## Claims

1. A system (200) for processing a web, wherein the web (402) has a first surface, a second surface opposite the first surface, and comprises a magnetic material, the system comprising:
a processing bed (202), wherein the processing bed is configured to support the web while the first surface of the web undergoes one or more processing steps, and wherein the processing bed includes a center portion (204) having a flat surface and side portions (206A, 206B) having curved surfaces;
a plurality of magnets (300), wherein the plurality of magnets are positioned relative to the processing bed so as to exert a magnetic force on the web that pulls the web toward the processing bed, and wherein the magnetic force is sufficient to shape the web so that the web substantially conforms to the flat surface and curved surfaces of the processing bed; and
a conveyor belt (404) configured to move the web over the processing bed while the web is shaped by the magnetic force to substantially conform to the flat surface and curved surfaces of the processing bed, wherein the conveyor belt has a first contact surface and a second contact surface opposite the first contact surface, wherein the first contact surface is configured to contact the second surface of the web, and **characterised in that** the second contact surface is configured to contact the processing bed, wherein the first contact surface of the conveyor belt is configured to apply traction to the second surface of the web such that the web moves along with the conveyor belt, and wherein second contact surface of the conveyor belt is configured to slide over the flat surface of the processing bed.

2. The system of claim 1, wherein the magnets are embedded in the processing bed.

3. The system of any of claims 1-2, wherein the curved surfaces of the processing bed extend upwardly from opposite sides of the flat surface of the processing bed.

4. The system of any of claims 1-3, wherein the web has a trough shape when shaped by the magnetic force to substantially conform to the flat surface and curved surfaces of the processing bed, and wherein the trough shape is capable of holding a fluid on the first surface of the web while the first surface of the web undergoes the one or more processing steps.

5. The system of claim 4, further comprising:
a fluid delivery apparatus positioned above the processing bed, wherein the fluid delivery apparatus is configured to deliver one or more chemicals in fluid form onto the first surface of the web while the web has the trough shape.

6. The system of claim 5, further comprising:
a fluid stirring apparatus positioned above the processing bed, wherein the fluid stirring apparatus is configured to stir the one or more chemicals in fluid form on the first surface of the web while the web has the trough shape.

7. The system of any of claims 1-6, wherein the processing bed comprises at least two sections heated to different temperatures.

8. The system of claim 7, further comprising:
at least one thermal divider disposed between the at least two section of the processing bed and configured to thermally isolate the two section from each other.

9. The system of any of claims 1-8, wherein the one or more processing steps relate to fabrication of photovoltaic cells.

10. A method for processing a web, wherein the web (402) has a first surface, a second surface opposite the first surface, and comprises a magnetic material, the method comprising:
supporting the web using a processing bed (202) while the first surface of the web undergoes one or more processing steps, wherein the processing bed includes a center portion having a flat surface and side portions having curved surfaces;
applying a magnetic force on the web using a plurality of magnets (300) positioned relative to the processing bed so as to pull the web toward the processing bed, wherein the magnetic force is sufficient to shape the web so that the web substantially conforms to the flat surface and curved surfaces of the processing bed; and
moving the web over the processing bed using a conveyor belt (404) while the web is shaped by the magnetic force to substantially conform to the flat surface and curved surfaces of the processing bed, wherein the conveyor belt has a first contact surface and a second contact surface opposite the first contact surface, wherein the first contact surface is configured to contact the second surface of the web, and **characterised in that** the second contact surface is configured to contact the processing bed;
wherein moving the web over the processing bed using comprises:
applying traction by the first contact surface of the conveyor belt to the second surface of the web such that the web moves along with the conveyor belt, wherein second contact surface of the conveyor belt is configured to slide over the flat surface of the processing bed.

11. The method of claim 10, further comprising:
delivering one or more chemicals in fluid form onto the first surface of the web while the web moves over the processing bed; and
stirring the one or more chemicals in fluid form on the first surface of the web using an array of fans without contacting the one or more chemicals.

12. The method of any of claims 10-11 wherein the substrate comprises a stainless steel support and an absorber layer and the chemical fluids comprise precursors to Cadmium sulfide.

## Patentansprüche

1. Ein System (200) zum Verarbeiten einer Bahn, wobei die Bahn (402) eine erste Oberfläche, eine der ersten Oberfläche entgegengesetzte zweite Oberfläche aufweist und ein magnetisches Material beinhaltet, wobei das System Folgendes beinhaltet:
ein Verarbeitungsbett (202), wobei das Verarbeitungsbett konfiguriert ist, die Bahn zu stützen, während die erste Oberfläche der Bahn einen oder mehrere Verarbeitungsschritte durchläuft, und wobei das Verarbeitungsbett einen mittleren Abschnitt (204) mit einer flachen Oberfläche und Seitenabschnitte (206A, 206B) mit gebogenen Oberflächen umfasst;
eine Vielzahl von Magneten (300), wobei die Vielzahl von Magneten relativ zu dem Verarbeitungsbett so positioniert sind, dass sie auf die Bahn eine Magnetkraft ausüben, welche die Bahn zu dem Verarbeitungsbett hin zieht, und wobei die Magnetkraft ausreicht, um die Bahn so zu formen, dass sich die Bahn im Wesentlichen an die flache Oberfläche und die gebogenen Oberflächen des Verarbeitungsbetts anpasst; und
ein Förderband (404), das konfiguriert ist, die Bahn über das Verarbeitungsbett zu bewegen, während die Bahn durch die Magnetkraft so geformt wird, dass sie sich im Wesentlichen an die flache Oberfläche und die gebogenen Oberflächen des Verarbeitungsbetts anpasst, wobei das Förderband eine erste Kontaktoberfläche und eine der ersten Kontaktoberfläche entgegengesetzte zweite Kontaktoberfläche aufweist, wobei die erste Kontaktoberfläche konfiguriert ist, die zweite Oberfläche der Bahn zu berühren, und **dadurch gekennzeichnet ist, dass**
die zweite Kontaktoberfläche konfiguriert ist, das Verarbeitungsbett zu berühren, wobei die erste Kontaktoberfläche des Förderbands konfiguriert ist, auf die zweite Oberfläche der Bahn eine Zugkraft anzuwenden, sodass sich die Bahn gemeinsam mit dem Förderband bewegt, und wobei die zweite Kontaktoberfläche des Förderbands konfiguriert ist, über die flache Oberfläche des Verarbeitungsbetts zu gleiten.

2. System gemäß Anspruch 1, wobei die Magneten in dem Verarbeitungsbett eingebettet sind.

3. System gemäß einem der Ansprüche 1-2, wobei sich die gebogenen Oberflächen des Verarbeitungsbetts von entgegengesetzten Seiten der flachen Oberfläche des Verarbeitungsbetts aufwärts erstrecken.

4. System gemäß einem der Ansprüche 1-3, wobei die Bahn eine Wannenform aufweist, wenn sie durch die Magnetkraft so geformt wird, dass sie sich im Wesentlichen an die flache Oberfläche und die gebogenen Oberflächen des Verarbeitungsbetts anpasst, und wobei die Wannenform in der Lage ist, auf der ersten Oberfläche der Bahn ein Fluid zu halten, während die erste Oberfläche der Bahn den einen oder die mehreren Verarbeitungsschritte durchläuft.

5. System gemäß Anspruch 4, das ferner Folgendes beinhaltet:
eine Fluidabgabevorrichtung, die über dem Verarbeitungsbett positioniert ist, wobei die Fluidabgabevorrichtung konfiguriert ist, eine oder mehrere Chemikalien in Fluidform auf die erste Oberfläche der Bahn abzugeben, während die Bahn die Wannenform aufweist.

6. System gemäß Anspruch 5, das ferner Folgendes beinhaltet:
eine Fluidrührvorrichtung, die über dem Verarbeitungsbett positioniert ist, wobei die Fluidrührvorrichtung konfiguriert ist, die eine oder die mehreren Chemikalien in Fluidform auf der ersten Oberfläche der Bahn zu rühren, während die Bahn die Wannenform aufweist.

7. System gemäß einem der Ansprüche 1-6, wobei das Verarbeitungsbett mindestens zwei Bereiche beinhaltet, die auf unterschiedliche Temperaturen erhitzt werden.

8. System gemäß Anspruch 7, das ferner Folgendes beinhaltet:
mindestens einen thermischen Teiler, der zwischen den mindestens zwei Bereichen des Verarbeitungsbetts angeordnet und konfiguriert ist, die zwei Bereiche voneinander thermisch zu isolieren.

9. System gemäß einem der Ansprüche 1-8, wobei der eine oder die mehreren Verarbeitungsschritte die Herstellung von photovoltaischen Zellen betreffen.

10. Ein Verfahren zum Verarbeiten einer Bahn, wobei die Bahn (402) eine erste Oberfläche, eine der ersten Oberfläche entgegengesetzte zweite Oberfläche aufweist und ein magnetisches Material beinhaltet, wobei das Verfahren Folgendes beinhaltet:
Stützen der Bahn unter Verwendung eines Verarbeitungsbetts (202), während die erste Oberfläche der Bahn einen oder mehrere Verarbeitungsschritte durchläuft, wobei das Verarbeitungsbett einen mittleren Abschnitt mit einer flachen Oberfläche und Seitenabschnitte mit gebogenen Oberflächen umfasst;
Anwenden einer Magnetkraft auf die Bahn unter Verwendung einer Vielzahl von Magneten (300), die relativ zu dem Verarbeitungsbett so positioniert sind, dass sie die Bahn zu dem Verarbeitungsbett hin ziehen, wobei die Magnetkraft ausreicht, um die Bahn so zu formen, dass sich die Bahn im Wesentlichen an die flache Oberfläche und die gebogenen Oberflächen des Verarbeitungsbetts anpasst; und
Bewegen der Bahn über das Verarbeitungsbett unter Verwendung eines Förderbands (404), während die Bahn durch die Magnetkraft so geformt wird, dass sie sich im Wesentlichen an die flache Oberfläche und die gebogenen Oberflächen des Verarbeitungsbetts anpasst, wobei das Förderband eine erste Kontaktoberfläche und eine der ersten Kontaktoberfläche entgegengesetzte zweite Kontaktoberfläche aufweist, wobei die erste Kontaktoberfläche konfiguriert ist, die zweite Oberfläche der Bahn zu berühren, und **dadurch gekennzeichnet ist, dass**
die zweite Kontaktoberfläche konfiguriert ist, das Verarbeitungsbett zu berühren;
wobei das Bewegen der Bahn über das Verarbeitungsbett unter Verwendung Folgendes beinhaltet:
Anwenden von Zugkraft auf die zweite Oberfläche der Bahn durch die erste Kontaktoberfläche des Förderbands, sodass sich die Bahn gemeinsam mit dem Förderband bewegt, wobei die zweite Kontaktoberfläche des Förderbands konfiguriert ist, über die flache Oberfläche des Verarbeitungsbetts zu gleiten.

11. Verfahren gemäß Anspruch 10, das ferner Folgendes beinhaltet:
Abgeben einer oder mehrerer Chemikalien in Fluidform auf die erste Oberfläche der Bahn, während sich die Bahn über das Verarbeitungsbett bewegt; und
Rühren der einen oder der mehreren Chemikalien in Fluidform auf der ersten Oberfläche der Bahn unter Verwendung einer Gruppierung von Gebläsen, ohne die eine oder die mehreren Chemikalien zu berühren.

12. Verfahren gemäß einem der Ansprüche 10-11, wobei das Substrat einen Edelstahlträger und eine Absorberschicht beinhaltet und die chemischen Fluide Präkursoren von Cadmiumsulfid beinhalten.

## Revendications

1. Un système (200) pour le traitement d'une bande, où la bande (402) présente une première surface, une deuxième surface opposée à la première surface, et comprend un matériau magnétique, le système comprenant :
un lit de traitement (202), où le lit de traitement est configuré afin de soutenir la bande pendant que la première surface de la bande subit une ou plusieurs étapes de traitement, et où le lit de traitement inclut une portion centrale (204) présentant une surface plate et des portions latérales (206A, 206B) présentant des surfaces courbes ;
une pluralité d'aimants (300), où la pluralité d'aimants sont positionnés relativement au lit de traitement de manière à exercer une force magnétique sur la bande qui attire la bande vers le lit de traitement, et où la force magnétique est suffisante pour façonner la bande de sorte que la bande épouse substantiellement la surface plate et les surfaces courbes du lit de traitement ; et
un tapis roulant (404) configuré afin de déplacer la bande par-dessus le lit de traitement pendant que la bande est façonnée par la force magnétique afin d'épouser substantiellement la surface plate et les surfaces courbes du lit de traitement, où le tapis roulant présente une première surface de contact et une deuxième surface de contact opposée à la première surface de contact, où la première surface de contact est configurée afin de se mettre en contact avec la deuxième surface de la bande, et
**caractérisé en ce que**
la deuxième surface de contact est configurée afin de se mettre en contact avec le lit de traitement, où la première surface de contact du tapis roulant est configurée afin d'appliquer une traction sur la deuxième surface de la bande de telle sorte que la bande se déplace conjointement avec le tapis roulant, et où la deuxième surface de contact du tapis roulant est configurée afin de glisser par-dessus la surface plate du lit de traitement.

2. Le système de la revendication 1, où les aimants sont incorporés dans le lit de traitement.

3. Le système de n'importe lesquelles des revendications 1 à 2, où les surfaces courbes du lit de traitement s'étendent vers le haut depuis des côtés opposés de la surface plate du lit de traitement.

4. Le système de n'importe lesquelles des revendications 1 à 3, où la bande présente une forme d'auge lorsque façonnée par la force magnétique afin d'épouser substantiellement la surface plate et les surfaces courbes du lit de traitement, et où cette forme d'auge est capable de contenir un fluide sur la première surface de la bande pendant que la première surface de la bande subit ces une ou plusieurs étapes de traitement.

5. Le système de la revendication 4, comprenant en sus :
un appareil de distribution de fluide positionné au-dessus du lit de traitement, où l'appareil de distribution de fluide est configuré afin de distribuer un ou plusieurs produits chimiques sous forme de fluide sur la première surface de la bande pendant que la bande présente cette forme d'auge.

6. Le système de la revendication 5, comprenant en sus :
un appareil d'agitation de fluide positionné au-dessus du lit de traitement, où l'appareil d'agitation de fluide est configuré afin d'agiter ces un ou plusieurs produits chimiques sous forme de fluide sur la première surface de la bande pendant que la bande présente cette forme d'auge.

7. Le système de n'importe lesquelles des revendications 1 à 6, où le lit de traitement comprend au moins deux sections chauffées jusqu'à différentes températures.

8. Le système de la revendication 7, comprenant en sus :
au moins une cloison thermique disposée entre ces au moins deux sections du lit de traitement et configurée afin d'isoler thermiquement les deux sections l'une de l'autre.

9. Le système de n'importe lesquelles des revendications 1 à 8, où ces une ou plusieurs étapes de traitement se rapportent à la fabrication de cellules photovoltaïques.

10. Un procédé pour le traitement d'une bande, où la bande (402) présente une première surface, une deuxième surface opposée à la première surface, et comprend un matériau magnétique, le procédé comprenant :
le soutien de la bande à l'aide d'un lit de traitement (202) pendant que la première surface de la bande subit une ou plusieurs étapes de traitement, où le lit de traitement inclut une portion centrale présentant une surface plate et des portions latérales présentant des surfaces courbes ;
l'application d'une force magnétique sur la bande à l'aide d'une pluralité d'aimants (300) positionnés relativement au lit de traitement de manière à attirer la bande vers le lit de traitement, où la force magnétique est suffisante pour façonner la bande de sorte que la bande épouse substantiellement la surface plate et les surfaces courbes du lit de traitement ; et
le déplacement de la bande par-dessus le lit de traitement à l'aide d'un tapis roulant (404) pendant que la bande est façonnée par la force magnétique afin d'épouser substantiellement la surface plate et les surfaces courbes du lit de traitement, où le tapis roulant présente une première surface de contact et une deuxième surface de contact opposée à la première surface de contact, où la première surface de contact est configurée afin de se mettre en contact avec la deuxième surface de la bande, et
**caractérisé en ce que**
la deuxième surface de contact est configurée afin de se mettre en contact avec le lit de traitement ;
où le déplacement de la bande par-dessus le lit de traitement à l'aide de comprend :
l'application d'une traction par la première surface de contact du tapis roulant sur la deuxième surface de la bande de telle sorte que la bande se déplace conjointement avec le tapis roulant, où la deuxième surface de contact du tapis roulant est configurée afin de glisser par-dessus la surface plate du lit de traitement.

11. Le procédé de la revendication 10, comprenant en sus :
la distribution d'un ou de plusieurs produits chimiques sous forme de fluide sur la première surface de la bande pendant que la bande se déplace par-dessus le lit de traitement ; et
l'agitation de ces un ou plusieurs produits chimiques sous forme de fluide sur la première surface de la bande à l'aide d'un ensemble de ventilateurs sans mise en contact avec ces un ou plusieurs produits chimiques.

12. Le procédé de n'importe lesquelles des revendications 10 à 11 où le substrat comprend un support en acier inoxydable et une couche d'absorbeur et les fluides chimiques comprennent des précurseurs de sulfure de cadmium.
